# EUROPEAN PATENT SPECIFICATION

(11) **EP 1 614 649 B1**
(45) Date of publication and mention of the grant of the patent: **18.09.2013**
(21) Application number: 04726310.8
(22) Date of filing: 07.04.2004
(51) Int. Cl.: B65H 37/04, C09J 5/00, H01L 21/68

(54) **METHOD AND DEVICE FOR STICKING TAPE**
VERFAHREN UND VORRICHTUNG ZUM KLEBEN VON BÄNDERN
PROCEDE ET DISPOSITIF PERMETTANT DE COLLER DES BANDES

(30) Priority: 09.04.2003 JP 2003105693
(43) Date of publication of application: 11.01.2006
(73) Proprietor: Lintec Corporation, Tokyo 173-0001 (JP)
(72) Inventor: NAKAYAMA, Takehito, 3340051 (JP)
(74) Representative: Piésold, Alexander James
(86) International application number: PCT/JP2004/005020
(87) International publication number: WO 2004/089797

(56) References cited:
- FR-A- 2 565 949
- JP-A- 6 100 842
- JP-A- 6 177 243
- JP-A- 10 330 022
- US-A- 5 472 554

## Description

### FIELD OF THE INVENTION

The present invention relates to a method and an apparatus for sticking a tape to an adherend such as a semiconductor wafer. More particularly, the invention relates to a method and an apparatus capable of preventing the warpage of an adherend to which a tape has been stuck.

### BACKGROUND OF THE INVENTION

In the manufacture of semiconductors, circuits are formed on the surface of a semiconductor wafer (simply "wafer" hereinafter) and the back surface of the wafer is ground to achieve a small and uniform thickness and to remove an oxide layer on the back surface.

The step of grinding the wafer back (backgrinding step) involves sticking of a protective tape to the wafer surface having circuits to protect the circuit surface.

In a common method of sticking a protective tape to a wafer, a protective tape sized larger than the wafer outer diameter is stuck, then a cutter 102 is inserted into the protective tape T at a position along the outer peripheral edge of the wafer W, and the protective tape T is cut out by swivelling the cutter 102 or a mounting table of the wafer W, as illustrated in Fig. 14 (see for example JP-A-H10-330022)

In another example, in US 5472554, a wafer is stuck onto masking film tape by passing the masking film tape and the wafer through upper and lower rollers.

The recent spread of IC cards and cellular phones has entailed further reduction of wafer thickness, and therefore semiconductor chips have been required to be reduced in thickness to 100 or 50 µm or below.

However, the production of such thin wafers has resulted in the following problem when a protective tape is stuck to a wafer by the above method prior to the backgrinding.

The problem is when the protective tape T is cut out to the size of outer periphery of the wafer W with slight contact of the cutter 102 with the outer periphery of the wafer W, the cutter 102 is likely to damage the outer peripheral edge of the wafer W. Thin wafers for fabrication of thin semiconductor chips as described above can crack from the damage and become brittle such that they break upon a small impact. Moreover, positioning the tip of the cutter 102 in the vicinity of the edge of the wafer W requires fine adjustment, and any misalignment can bring the cutter 102 into contact with the wafer W to damage the outer peripheral edge of the wafer W.

The protective tape stuck to the wafer is generally long and tensioned, namely, the protective tape having a tension is stuck to the wafer. Accordingly, the protective tape stuck to the wafer keeps a substantial residual stress. Thinning such wafers by backgrinding lowers the wafer's strength and easily results in warpage.

Approaches to the aforesaid problems have been made from viewpoints of protective tapes and sticking apparatuses, but have not led to a sufficient solution.

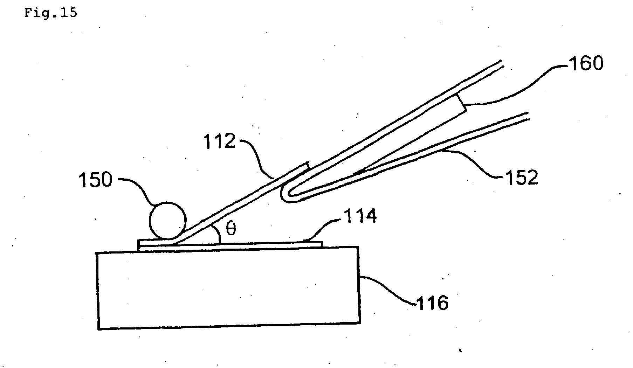

In a conventional approach, a protective tape is previously cut to approximately the shape of a wafer and is stuck to the wafer. This method is illustrated in Fig. 15, in which a protective tape 112 cut to the shape of a wafer 114 is delivered to the wafer 114 by folding a release film 152 at a sharp angle by means of a peel plate 160 above the wafer 114; the protective tape 112 is stuck to the wafer 114 by relative movement of a mounting table 116 and a press roll 150.

This conventional method, however, causes the protective tape 112 to have a large angle θ to the wafer 114 because of the presence of the peel plate 160. Therefore, the protective tape 112 largely changes the traveling direction at the press roll 150, requiring a further tension. As such, the problem of wafer warpage is not fully solved.

The warpage problem can occur not only when protective tapes are stuck to wafers, but also in the sticking of die-attach films to silicon wafers or IC chips, optical films such as polarizing films and phase difference films to LCD panels, labels to compact discs, and coverlay films to flexible substrates.

The present invention has been made to solve the problems mentioned hereinabove. It is therefore an object of the invention to provide a method and an apparatus for sticking a tape capable of preventing the warpage of an adherend to which the tape has been stuck.

### DISCLOSURE OF THE INVENTION

A method for sticking a tape according to the present invention is capable of sticking a tape having a sticky surface to a surface of an adherend, and comprises:
preparing the tape for sticking to the adherend;
attaching the tape via a non-sticky surface to a support film having a sticky and removable surface via the surface;
while subjecting the support film to tension, causing the sticky surface of the tape on the support film to be opposed to a surface of the adherend mounted on a mounting table;
sticking the tape to the adherend by pressing the support film; and
releasing the support film from the tape.

In the method, the tape is cut beforehand to shape for sticking to the adherend and is thereafter attached to and held on the support film. Accordingly, the tape can be opposed to and stuck to the adherend while the tension to the tape is diffused to the support film. Moreover, the tape can be approximated to the adherend and be stuck thereto at a small angle, so that the tension required for the sticking can be reduced. Accordingly, the tape stuck to the adherend has less residual stress and the adherend can be prevented from warpage.

Preferably, the method for sticking a tape according to the present invention comprises attaching a plurality of the tapes to the long support film along a longer direction, and transferring the support film whereby the tapes are stuck to respective adherends by repetition of operations (i) to (iv):
(i) causing the sticky surface of the tape on the support film to be opposed to a surface of the adherend mounted on the mounting table;
(ii) sticking the tape to the adherend by pressing the support film;
(iii) releasing the support film from the tape; and
(iv) mounting a new adherend on the mounting table.

In the method, a plurality of the tapes to be stuck to adherends are attached to the long support film across the longer length, and the support film is transferred to cause each tape to be opposed to and be stuck to the respective adherend on the mounting table. Therefore, continuous sticking of the tapes to respective adherends can be thus achieved.

Preferably, the method for sticking a tape according to the present invention involves a frame member for fixing the support film and comprises:
attaching and fixing the support film to the frame member such that the tape is included in a frame of the frame member;
causing the sticky surface of the tape in the frame of the frame member to be opposed to a surface of the adherend mounted on the mounting table; and
sticking the tape to the adherend by pressing the support film in the frame of the frame member.

In the method, the support film is fixed with the frame member and the tape in the frame is stuck to the adherend. Because of the frame member, the support film in the frame of the frame member is isolated and free from the tension to the support film out of the frame. Accordingly, the tape attached to the support film in the frame can be stuck in a less tensioned state. Therefore, the tape stuck to the adherend has less residual stress and the possibility of the adherend being warped can be further reduced.

Preferably, the method for sticking a tape according to the present invention comprises relatively moving the frame member to which the support film is attached and the mounting table on which the adherend is mounted to perform alignment of the tape in the frame of the frame member with the adherend.

According to this structure, relative movement of the frame member and the mounting table in a vertical direction permits the tape and the support film to be approximated sufficiently to the adherend to which they are stuck. Therefore, the tension to the tape during sticking can be reduced. Moreover, relative movement of the frame member and the mounting table in a horizontal direction permits the tape and the support film to be aligned with the adherend to which they are stuck. Therefore, the sticking can be accomplished accurately without misalignment.

Preferably, the method for sticking a tape according to the present invention involves:
a fixing roll for attaching and fixing the support film to the frame member;
a. sticking roll for sticking the tape to the adherend;
a wind-up roll for the support film; and
a fixed end of the support film;
and comprises:
   moving the fixing roll toward the frame member while causing the fixing roll to press the support film between the wind-up roll and the fixed end, thereby transferring the tape attached to the support film between the wind-up roll and the fixing roll in a direction opposite to the wind-up direction such that the tape is included in the frame of the frame member;
   causing the fixing roll to press the support film to fix the support film to the frame member;
   causing the sticking roll to press the support film in the frame of the frame member to stick the tape to the adherend; and
   moving the fixing roll away from the frame member simultaneously with releasing the support film from the tape and winding up the support film on the wind-up roll.

Preferably, the method for sticking a tape according to the present invention involves:
a fixing roll for attaching and fixing the support film to the frame member;
a sticking roll for sticking the tape to the adherend; and
a clamping member for clamping the support film across the width;
and comprises:
   clamping the support film at longer edge portions thereof with the clamping member and arranging the tape such that the tape is included in the frame of the frame member;
   causing the fixing roll to press the support film to fix the support film to the frame member;
   causing the sticking roll to press the support film in the frame of the frame member to stick the tape to the adherend; and
   releasing the support film from the tape by relatively moving the clamping member.

Preferably, in the methods for sticking a tape according to the present invention, the adherend is a semiconductor wafer and the tape is a protective tape.

An apparatus for sticking a tape according to the present invention is adapted to stick a tape having a sticky surface to a surface of an adherend, and comprises:
a mounting table on which the adherend is mounted;
a frame member provided to include an adherend-mounting surface of the mounting table;
a fixing roll for attaching and fixing a long support film to the frame member, the support film having a sticky and removable surface to which the tape is attached; and
a sticking roll for sticking the tape to the adherend;
the apparatus being constructed such that:
   the support film is arranged above the frame member so that the tape is included in a frame of the frame member;
   the fixing roll is caused to press the support film to fix the support film to the frame member;
   the sticking roll is caused to press the support film in the frame of the frame member to stick the tape to the adherend; and
   the support film is released from the tape.

Preferably, the apparatus for sticking a tape according to the present invention further comprises:
a wind-up roll for the support film; and
a fixed end of the support film;
the apparatus being constructed such that:
   the fixing roll is moved toward the frame member while pressing the support film between the wind-up roll and the fixed end, thereby transferring the tape attached to the support film between the wind-up roll and the fixing roll in a direction opposite to the wind-up direction such that the tape is included in the frame of the frame member;
   the fixing roll is caused to press the support film to fix the support film to the frame member;
   the sticking roll is caused to press the support film in the frame of the frame member to stick the tape to the adherend; and
   the fixing roll is moved away from the frame member and simultaneously the support film is released from the tape and is wound on the wind-up roll.

Preferably, the apparatus for sticking a tape according to the present invention further comprises a clamping member for clamping the support film across the width, the apparatus being constructed such that:
the support film is clamped at longer edge portions thereof with the clamping member and the tape is arranged such that the tape is included in the frame of the frame member;
the fixing roll is caused to press the support film to fix the support film to the frame member;
the sticking roll is caused to press the support film in the frame of the frame member to stick the tape to the adherend; and
the support film is released from the tape by relatively moving the clamping member.

Preferably in the apparatuses according to the present invention, the tape is formed beforehand to shape for sticking to the adherend and is thereafter attached to and held on the support film. Accordingly, the tape can be opposed to and stuck to the adherend while the tension to the tape is diffused to the support film. Moreover, the tape can be approximated to the adherend and be stuck thereto at a small angle, so that the tension required for the sticking can be reduced. Accordingly, the tape stuck to the adherend has less residual stress and the adherend can be prevented from warpage.

Further, the support film is fixed by the frame member and the tape in the frame is stuck to the adherend. Because of the frame member, the support film in the frame of the frame member is isolated and free from the tension to the support film out of the frame. Accordingly, the tape attached to the support film in the frame can be stuck in a less tensioned state. Therefore, the tape stuck to the adherend has less residual stress and the adherend can be prevented from warpage.

Furthermore, a plurality of the tapes to be stuck to adherends are attached to the long support film along the longer direction, and the support film is transferred to cause each tape to be opposed to and be stuck to the respective adherend on the mounting table. Continuous sticking of the tapes to respective adherends can be thus achieved.

Preferably, the apparatus for sticking a tape according to the present invention further comprises aligning means capable of relatively moving the frame member to which the support film is attached and the mounting table on which the adherend is mounted to perform alignment of the tape in the frame of the frame member with the adherend.

The aligning means performing relative movement of the frame member and the mounting table in a vertical direction permits the tape and the support film to be approximated sufficiently to the adherend to which they are stuck. Therefore, the tension to the tape during sticking can be reduced. Moreover, relative movement of the frame member and the mounting table in a horizontal direction permits the tape and the support film to be aligned with the adherend to which they are stuck. Therefore, the sticking can be accomplished accurately without misalignment.

In another aspect, the apparatus for sticking a tape according to the present invention is adapted to stick a tape having a sticky surface to a surface of an adherend, and comprises:
a mounting table on which the adherend is mounted;
a press roll for pressing a long support film having a sticky and removable surface to which the tape is attached, to stick the tape to the adherend; and
a clamping member for clamping the support film across a width thereof;
the apparatus being constructed such that:
   the support film is clamped at longer edge portions thereof with the clamping member and the clamping member is moved to cause the sticky surface of the tape on the support film to be opposed to a surface of the adherend mounted on the mounting table;
   the press roll is caused to press the support film to stick the tape to the adherend; and
   the support film is released from the tape by relatively moving the clamping member.

Preferably in the apparatuses for sticking a tape according to the present invention, the adherend is a semiconductor wafer and the tape is a protective tape.

### BRIEF DESCRIPTION OF THE DRAWINGS

Fig. 1 is a set of front views explaining the sticking operations by a method of the present invention;
Fig. 2 is a set of front views illustrating the sticking involving a frame member by a method of the present invention;
Fig. 3 is a top view of Fig. 2;
Fig. 4 is a set of front views illustrating arrangements of a frame member and a mounting table;
Fig. 5 is a top view illustrating a configuration of the frame member;
Fig. 6 is a top view illustrating a configuration of the frame member;
Fig. 7 is a set of front views illustrating an embodiment of an apparatus according to the present invention;
Fig. 8 is a top view of the apparatus of the embodiment shown in Fig. 7;
Fig. 9 is a set of front views illustrating an embodiment of how a protective tape is stuck and a release film is released in the embodiment of Fig. 7;
Fig. 10 is a set of front views illustrating an embodiment of an apparatus according to the present invention;
Fig. 11 is a top view of the apparatus of the embodiment shown in Fig. 10;
Fig. 12 is a set of front views illustrating an embodiment of an apparatus according to the present invention;
Fig. 13 is a set of perspective views illustrating how a tape to be stuck to an adherend is laminated with a support film;
Fig. 14 is a perspective view illustrating how the protective tape stuck to a wafer is cut to the shape of the wafer; and
Fig. 15 is a front view showing a conventional way for sticking a protective tape previously cut to wafer shape to a wafer.

### PREFERRED EMBODIMENTS OF THE INVENTION

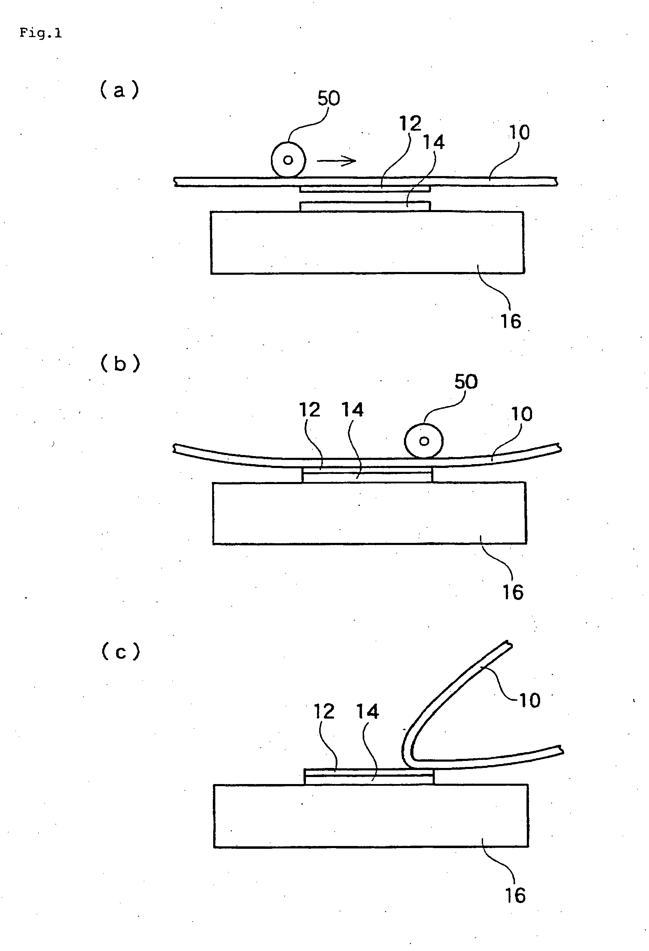

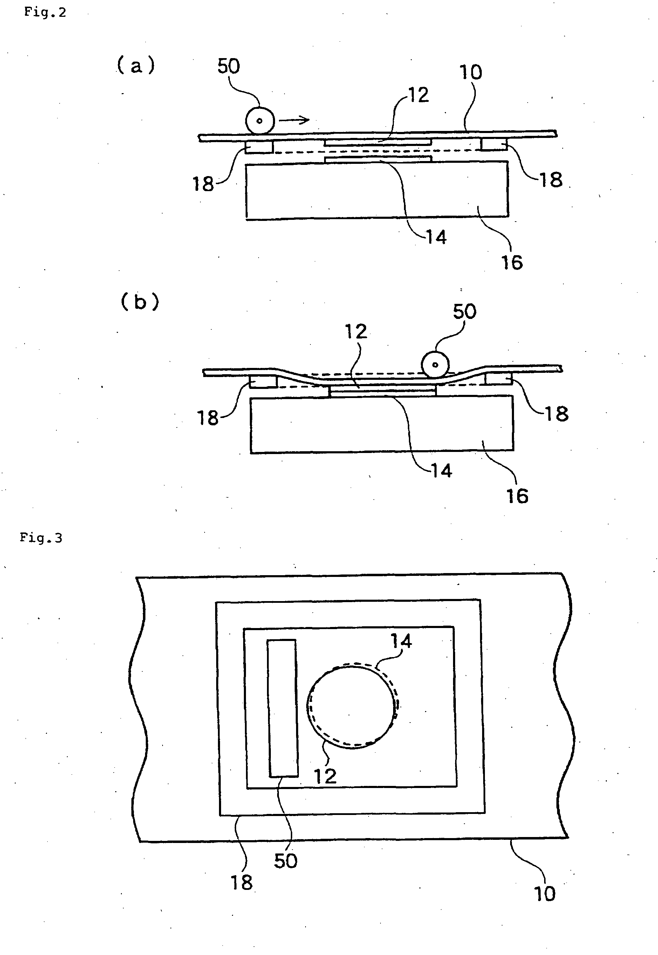

Embodiments of the present invention will'be described hereinbelow with reference to drawings. Fig. 1 is a set of front views explaining the sticking operations by a method of the present invention. Fig. 2 is a set of front views illustrating the sticking involving a frame member by a method of the present invention. Fig. 3 is a top view of Fig. 2.

As illustrated in Fig. 1, a tape 12 of a size corresponding to that of an adherend 14 is prepared beforehand, and, with the tape 12 being attached to a support film 10, the support film 10 is pressed to stick the tape 12 to the adherend 14.

When the tape 12 is being stuck to the adherend 14, the support film 10 is held in a planar state with tension (Fig. 1 (a)). In this state, the tape 12 attached to the support film 10 is held in a less tensioned state because the tension is stuck to the thick laminate of the support film 10 and the tape 12 and is diffused to the support film 10.

The tape 12 held in the above state is aligned with and opposed to the adherend 14 mounted on a mounting table 16, and a press roll 50 is rotated over the support film 10 to press and stick the tape 12 to the adherend 14 (Fig. 1(b)).

Because the tape 12 can be held in a planar state without excess tensions while the support film 10 is tensioned as mentioned above, the tape 12 can be stuck to the adherend 14 with reduced residual stress. Therefore, the adherend 14 to which the tape 12 has been stuck can be effectively prevented from warpage.

Referring to the support film 10, the surface to which the tape 12 is attached has sticking properties such that the surface can hold the tape 12 and possesses removable properties such that the tape 12 can be released therefrom after the tape 12 has been stuck to the adherend 14. Therefore, the support film 10 can be released from the tape 12 after the tape 12 has been stuck to the adherend 14 (Fig. 1(c)).

The support film 10 may be formed by producing a sticky and removable layer on a flexible substrate film by sticking a removable pressure-sensitive adhesive. The support films are not limited to pressure-sensitive adhesive coated films, and any films may be used as long as the tape 12 can be attached and held thereto and be released therefrom.

The tape 12 is formed to size corresponding to that of the adherend 14 by previously punching a long tape to desired shape. For example, when the protective tape 12 is stuck to the adherend 14 being a wafer, the protective tape 12 punched approximately to shape of the round wafer is prepared and is attached to the support film 10. It will be appreciated that the tape 12 may have a size somewhat larger or smaller than that of the adherend 14.

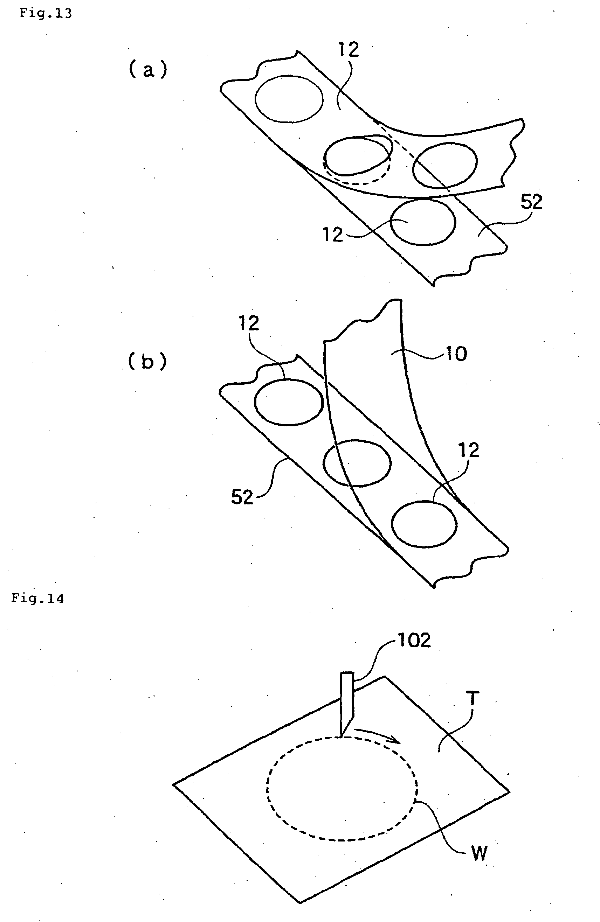

Fig. 13 illustrates an embodiment of how the tape 12 is attached to the support film 10. Herein, the attachment of a wafer-shaped protective tape to a support film will be described as an example. As shown in Fig. 13(a), the protective tape 12 is formed long and has a pressure-sensitive adhesive layer to which a release film 52 is attached along a longer direction. The long protective tape 12 is cut out in a circular shape by swiveling a blade of rotary die cutter that is fitted with a cut-shaped blade on a roll face over the protective tape 12 or by cutting and inserting a blade of flat die cutter in a circular motion, without cutting the release film 52. Subsequently, the protective tape 12 is released and removed while leaving the circular portions. Thereafter, the support film 10 approximately of the same width as the release film 52 is laminated to the release film 52 having the circular protective tapes 12 thereon (Fig. 13(b)). Thus, the long support film 10 supports a plurality of the protective tapes 12, 12 ... attached separately from each other along a longer direction.

As described above, the present invention reduces the residual stress of the tape 10 stuck to the adherend 14 and thereby prevents the warpage of the adherend 14 by sticking the tape 12 to the adherend 14 with the tape 12 being attached to the long support film 10. Furthermore, Figs. 2 and 3 illustrate another embodiment of the present invention. As illustrated, a frame member 18 is arranged in a position along the outer circumference of the adherend 14, and the support film 10 is attached to the frame member 18 so that the tape 10 to be stuck to the adherend 14 will be included by the frame member 18 (Fig. 2(a)). The support film 10 in the frame is then pressed to stick the tape 12 to the adherend 14 (Fig. 2 (b)). By attaching and fixing the support film 10 to the frame member 18 as above, the support film 10 in the frame of the frame member 18 is blocked the tension to the support film 10 out of the frame.

Specifically, the support film 10 in the frame of the frame member 18 is attached to the frame member 18 and is blocked via the frame member 18 from the tension to the support film 10 out of the frame. Accordingly, excessive tensions to the framed support film can be avoided. Furthermore, as described above, the tape 12 attached to the support film 10 is held in a less tensioned state because the tension is diffused to the support film 10. Therefore, pressing the framed support film 10 can stick the tape 12 to the adherend 14 with the residual stress of the tape 12 stuck to the adherend being further reduced, thereby effectively preventing the warpage of the adherend 14.

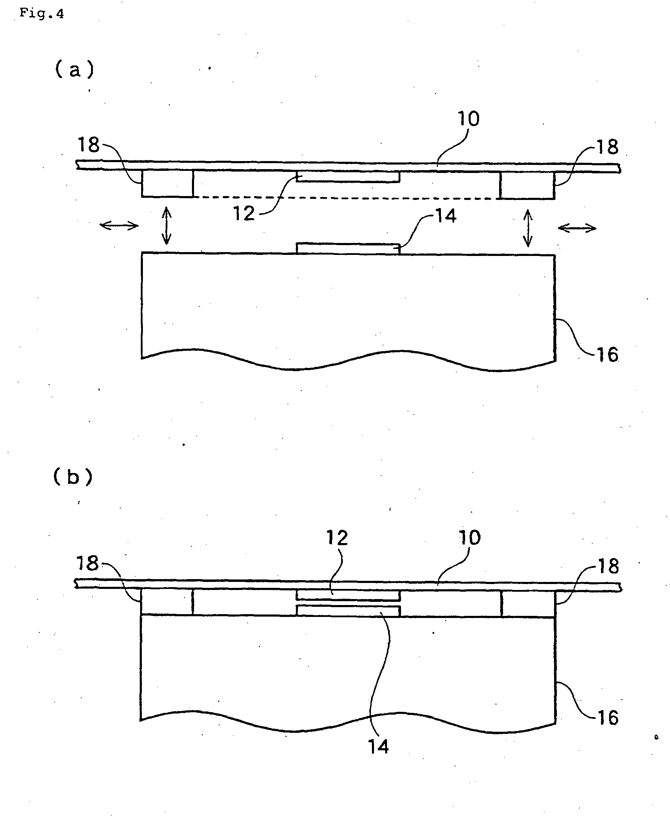

The frame member 18 is arranged above the upper surface of the mounting table 16 so as to include the adherend-mounting surface that is defined at a position on which the adherend 14 is mounted. The frame member 18 and the mounting table 16 are preferably arranged to permit free relative movement in a vertical direction by means of aligning means capable of adjusting their relative positions, as illustrated in Fig. 4 (a) . Descending the frame member 18 or ascending the mounting table 16 approximates the adherend 14 and the tape 12 adequately, so that the subsequent pressing can be performed with high position accuracy while reducing the residual stress of the tape 12. Further preferably, the frame member 18 and the mounting table 16 are arranged to permit free relative movement in a horizontal direction by means of the aligning means so as to adjust the overlap of the adherend 14 and the tape 12.

Provided that conditions permit adequate alignment of the adherend 14 and the tape 12, the frame member 18 having a height such that the adherend 14 and the tape 12 have an appropriate clearance may be fixed to the mounting table 16 as shown in Fig. 4(b).

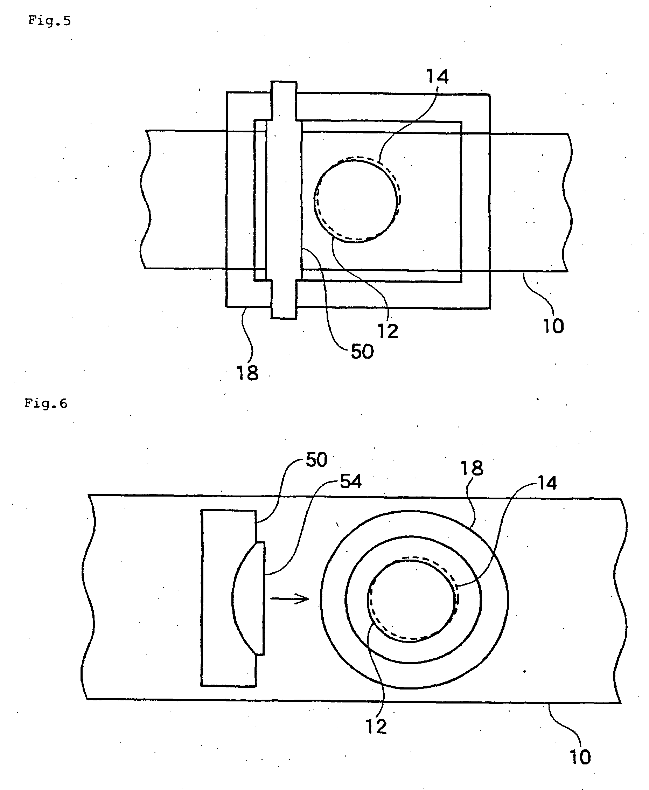

The shape of the frame member 18 is not particularly limited and may be square as illustrated in Fig. 3. In the illustrated case, when the support film 10 is pressed with the press roll 50, the principal surface of the press roll 50 should be smaller than the width of the frame member 18 and the width of the support film 10 may be smaller than the width of the frame member 18, as shown in Fig. 5.

For the adherend 14 being circular as a wafer, the frame member 18 may be a circular shape having a size slightly larger than that of the adherend, as illustrated in Fig. 6. In this case, the principal surface of the press roll 50 defines a circular protrudent portion 54 having a diameter larger than that of the wafer; the press roll 50 is rotated over the frame member 18 to cause the protrudent portion 54 to press the support film 10.

Hereinbelow, the sticking apparatuses according to the invention will be described with reference to an embodiment in which the protective tape is stuck to the adherend being a wafer.

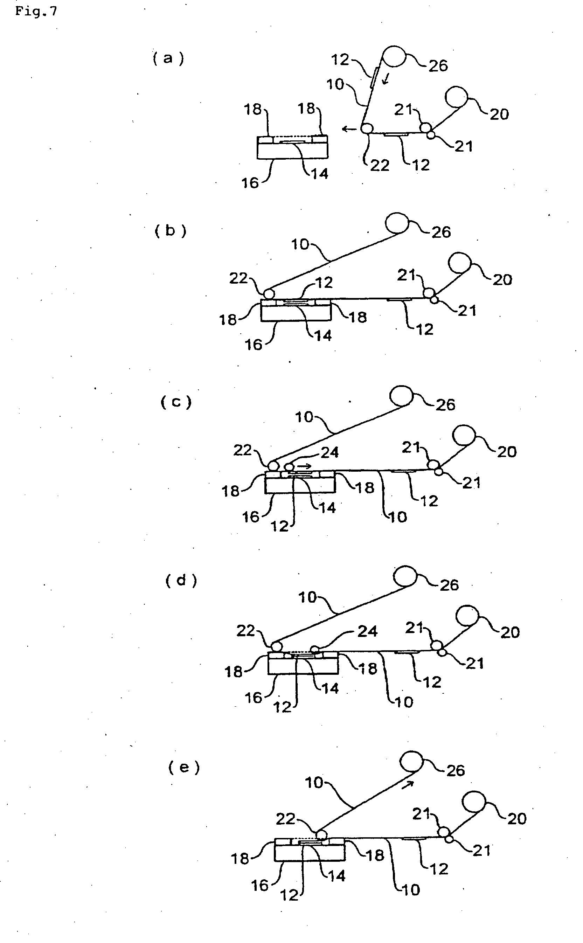

The sticking apparatus of an embodiment shown in Fig. 7 includes a frame member 18 and a mounting table 16 as described above, and further includes a fixing roll 22 for attaching and fixing a support film 10 to the frame member 18, a sticking roll 24 for sticking a protective tape 12 to a wafer 14, and a wind-up roll 26 for the support film 10. In the figure, 20 denotes a feed out roll that feeds out the support film 10, and 21 denotes pinch rolls.

The frame member 18 is provided above the mounting table 16 so as to include an adherend-mounting surface of the mounting table. In the present embodiment, the frame member and the mounting table are arranged to permit relative movement in horizontal and vertical directions by means of aligning means (not shown), as illustrated in Fig. 4(a). This structure permits alignment of the wafer 14 on the mounting table 16 with the protective tape 12 so as to overlap the wafer 14 and the protective tape 12 with a predetermined positional relation and to approximate them adequately in an opposed relation. The adherend-mounting surface of the mounting table 16 is formed with a plurality of pores, through which a vacuum apparatus suctions through a vacuum tube or the like to fix by suction the wafer 14 to the adherend-mounting surface of the mounting table 16.

The apparatus of the present embodiment performs the following operations to apply the protective tape 12 to the wafer 14.

The first operation involves feed of the support film 10 from the feed out roll 20 and winding thereof on the wind-up roll 26. This transfers the protective tape 12 stuck to the support film 10 to between the wind-up roll 26 and the fixing roll 22 (Fig. 7(a)).

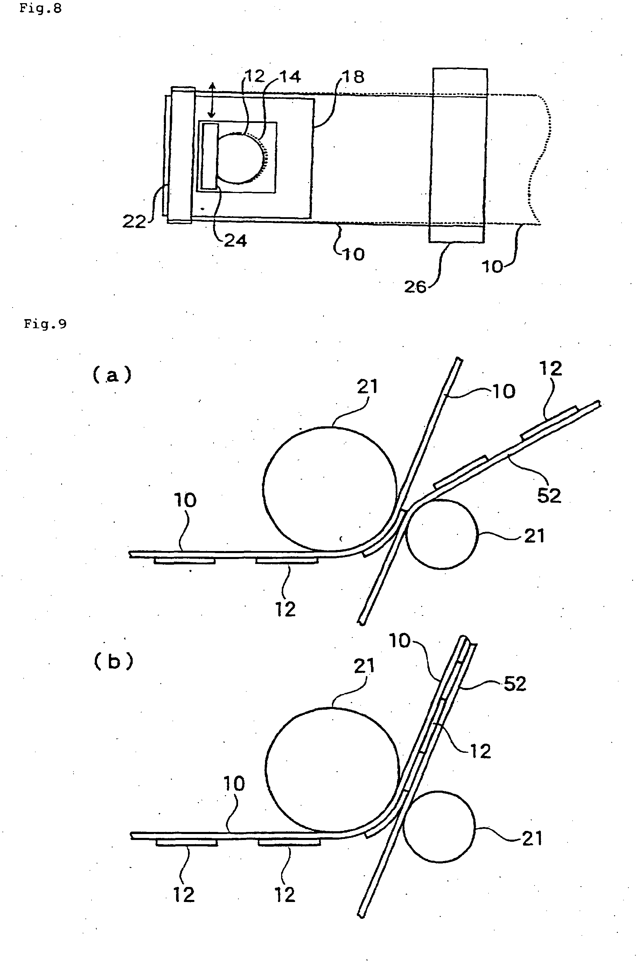

The protective tapes 12 may be attached to the support film 10 by means of the pinch rolls 21 as illustrated in Fig. 9(a). Alternatively, the protective tapes 12 may be previously cut out on the release film 52 and be laminated with the support film 10, and the release film 52 may be released by means of the pinch rolls 21, as illustrated in Fig. 9(b)

. Subsequently, the feed out roll 20 is stopped to cancel the feed of the support film 10, and the fixing roll 22 is moved toward the frame member 18 while pressing the support film 10 between the wind-up roll 26 and a fixed end of the support film 10 (feed out roll 20). Consequently, the protective tape 12 that has been previously positioned between the wind-up roll 26 and the fixing roll 22 is transferred away from the wind-up roll 26 in a direction opposite to the wind-up direction. The protective tape 12 is then transferred via the fixing roll 22 and is arranged so as to be included in the frame of the frame member 18 (Fig. 7(b)).

In the state described above, the fixing roll 22 presses the support film 10 against the frame member 18 to fix the support film.

Subsequently, the frame member 18 and the mounting table 16 are aligned by relative movements as necessary; for example, the protective tape 12 and the wafer 14 are approximated and opposed to each other with a clearance of about 1 to 3 mm. Thereafter, the sticking roll 24 is moved on the upper surface of the frame member 18 (Fig. 7(c) and Fig. 8) and is rotated over the framed support film 10 to press the same and to stick the protective tape 12 to the wafer 14 (Fig. 7(d)).

After completion of the sticking of the protective tape to the wafer 14, the sticking roll 24 is moved out of the frame of the frame member 18. Subsequently, the fixing roll 22 is moved away from the frame member 18, and the support film 10 is released from the protective tape 12 and is wound on the wind-up roll 26 (Fig. 7(e)).

After the wafer 14 with the protective tape 12 stuck thereon has been dismounted from the mounting table 16, a new wafer is delivered and mounted. These operations may be manual or fully automated. When the new wafer 14 has been mounted on the mounting table 16, the aforementioned operations are repeated to apply the protective tapes 12, 12 ... each to the respective wafers 14, 14 ....

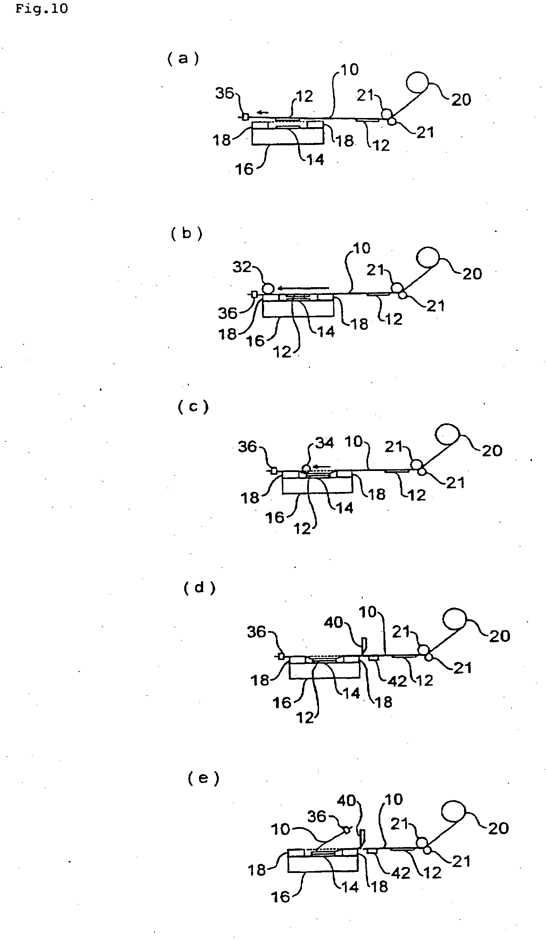

The sticking apparatus of an embodiment shown in Fig. 10 includes a mounting table 16, a frame member 18, a fixing roll 32 for attaching and fixing a support film 10 to the frame member 18, a sticking roll 34 for sticking a protective tape 12 to a wafer 14, and chucks (clamping member) 36 for clamping the support film 10 at edge portions thereof across the width.

The frame member 18 is provided above the mounting table 16 so as to include an adherend-mounting surface of the mounting table. In the present embodiment, the frame member and the mounting table are arranged to permit relative movement in horizontal and vertical directions by means of aligning means (not shown). This structure permits alignment of the wafer 14 on the mounting table 16 with the protective tape 12 so as to overlap the wafer 14 and the protective tape 12 with a predetermined positional relation and to approximate them adequately in an opposed relation.

The apparatus of the present embodiment performs the following operations to apply the protective tape 12 to the wafer 14. First, a pair of the chucks 36 clamp edge portions of the support film 10 and one pass of the support film 10 is withdrawn from the feed out roll 20 while the chucks 36 pull the support film; the support film is held so as to cover the frame member 18. In the above operation, the feed out roll 20 may be rotated with a torque motor or the like in a direction opposite to the feeding direction of the support film 10 to maintain the tension of the support film 10 between the feed out roll 20 and the chucks 36. The protective tape 12 is then arranged so as to be included in the frame of the frame member 18 (Fig. 10(a)).

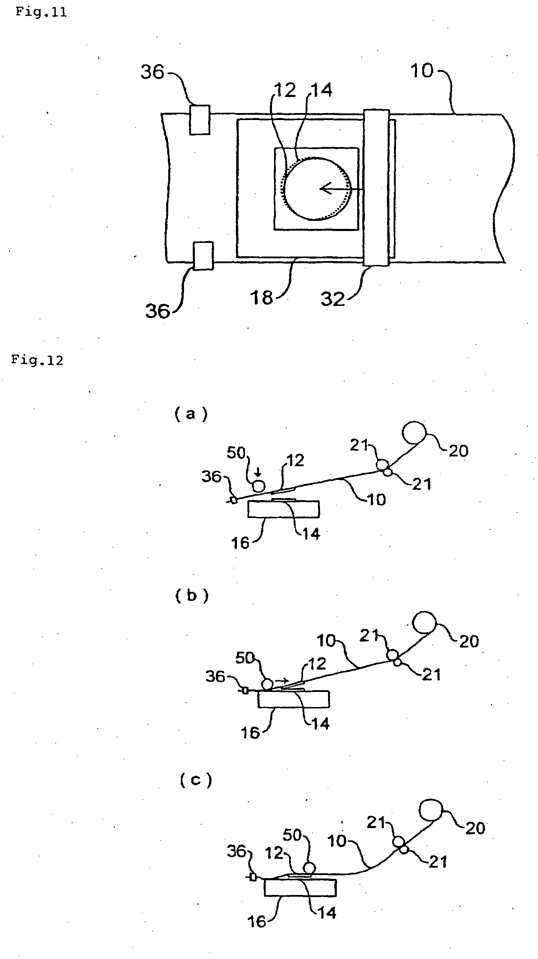

Subsequently, the fixing roll 32 is moved over the upper surface of the frame member 18 and presses the support film 10 to fix the same to the frame member 18 (Fig. 10 (b) and Fig. 11).

Thereafter, the frame member 18 and the mounting table 16 are aligned by relative movements as necessary; for example, the protective tape 12 and the wafer 14 are approximated and opposed to each other with a clearance of about 1 to 3 mm. Subsequently, the sticking roll 34 is moved on the upper surface of the frame member 18 and is rotated over the framed support film 10 to press the same and to stick the protective tape 12 to the wafer 14 (Fig. 10(c)).

After completion of the sticking of the protective tape 12 to the wafer 14, the sticking roll 34 is moved out of the frame of the frame member 18. Subsequently, the support film 10 is released from the protective tape 12 stuck to the wafer 14 by predetermined means. The present embodiment involves a cutter 40, which cuts the support film 10 being held by holding means 42 capable of fixing through adhesion of the support film (Fig. 10(d)); thereafter the chucks 36 clamping the support film 10 cut off are moved to release the support film 10 from the protective tape 12. After the wafer 14 with the protective tape 12 stuck thereon has been dismounted from the mounting table 16, a new wafer is delivered and mounted. When the new wafer 14 has been mounted on the mounting table 16, the aforementioned operations are repeated to stick the protective tapes 12, 12 ... each to the respective wafers 14, 14 ....

The sticking apparatus of an embodiment shown in Fig. 12 includes a mounting table 16 for mounting a wafer 14, a press roll 50 for pressing a support film 10 to stick a protective tape 12 to the wafer 14, and chucks 36 for clamping the support film 10 at edge portions thereof across the width.

The apparatus of the present embodiment performs the following operations to stick the protective tape 12 to the wafer 14. First, a pair of the chucks 36 clamp edge portions of the support film 10 and one pass of the support film 10 is withdrawn from the feed out roll 20 while the chucks 36 pull the support film; the support film is held so as to cover the mounting table 16. In the above operation, the feed out roll 20 may be rotated with a torque motor or the like in a direction opposite to the feeding direction of the support film 10 to maintain the tension of the support film 10 between the feed out roll 20 and the chucks 36. The support film 10 is then arranged so that the sticky surface of the protective tape 12 on the support film 10 is opposed to a surface of the wafer 14 on the mounting table (Fig. 12(a)).

Subsequently, the press roll 50 is brought into contact with the mounting table 16 through the support film 10 (Fig. 12(b)) and is rotated toward the wafer 14 to press the protective tape 12 to the wafer 14 through the support film 10 and to stick the protective tape to the wafer (Fig. 12 (c)). This sticking operation is preferably performed in a manner such that the tension by the rotation of the feed out roll 20 in a direction opposite to the feed out direction of the support film 10 is relaxed by controlling the drive of the torque motor to an extent such that the support film 10 that is not stuck to any wafer 14 will not contact with any wafer 14. This reduces the tension to the protective tape 12 and leads to further reduction of warpage of the wafer 14 to which the protective tape 12 has been stuck.

After completion of the sticking of the protective tape to the wafer 14, the support film 10 is released from the protective tape 12 stuck to the wafer 14 by operations similar to those of the embodiment shown in Fig. 10 ((d) and (e)). When the support film 10 has been released and a new wafer 14 has been mounted on the mounting table 16, the aforementioned operations are repeated to stick the protective tapes 12, 12 ... each to the respective wafers 14, 14 ....

The present invention is not limited to the embodiments presented hereinabove and any modifications and alternations are possible without departing from the scope of the present invention.

The present invention can be applied not only to the sticking of protective tapes to wafers but also to any cases in which the adherend can be warped by residual stress of the tape stuck thereto, with examples including the sticking of die-attach films (used for bonding IC chips to lead frames or substrates) to silicon wafers or IC chips, optical films such as polarizing films and phase difference films to LCD panels, labels to compact discs, and coverlay films to flexible substrates.

## Claims

1. A method for sticking a tape (12) having a sticky surface to a surface of an adherend (14), comprising:
preparing the tape for sticking to the adherend
**characterised by**:
attaching the tape via a non-sticky surface to a support film (10) having a sticky and removable surface via the surface;
while subjecting the support film to tension, causing the sticky surface of the tape on the support film to be opposed to a surface of the adherend mounted on a mounting table (16);
sticking the tape to the adherend by pressing the support film; and
releasing the support film from the tape.

2. The method for sticking a tape (12) according to claim 1, which comprises attaching a plurality of the tapes to the support film (10) along a longer direction, and transferring the support film whereby the tapes are stuck to respective adherends (14) by repetition of operations (i) to (iv):
(i) causing the sticky surface of the tape on the support film to be opposed to a surface of the adherend mounted on the mounting table;
(ii) sticking the tape to the adherend by pressing the support film;
(iii) releasing the support film from the tape; and
(iv) mounting a new adherend on the mounting table.

3. The method for sticking a tape (12) according to claim 1 or 2, which involves a frame member (18) for fixing the support film (10) and comprises:
attaching and fixing the support film to the frame member such that the tape is included in a frame of the frame member;
causing the sticky surface of the tape in the frame of the frame member to be opposed to a surface of the adherend mounted on the mounting table (16); and
sticking the tape to the adherend by pressing the support film in the frame of the frame member.

4. The method for sticking a tape (12) according to claim 3, which comprises relatively moving the frame member (18) to which the support film (10) is attached and the mounting table (16) on which the adherend is mounted to perform alignment of the tape in the frame of the frame member with the adherend.

5. The method for sticking a tape according to claim 3 or 4, which involves:
a fixing roll (22) for attaching and fixing the support film (10) to the frame member (18);
a sticking roll (24) for sticking the tape to the adherend;
a wind-up roll (26) for the support film; and
a fixed end of the support film;
and comprises:
moving the fixing roll toward the frame member while causing the fixing roll to press the support film between the wind-up roll and the fixed end, thereby transferring the tape attached to the support film between the wind-up roll and the fixing roll in a direction opposite to the wind-up direction such that the tape is included in the frame of the frame member;
causing the fixing roll to press the support film to fix the support film to the frame member;
causing the sticking roll (24) to press the support film in the frame of the frame member to stick the tape to the adherend; and
moving the fixing roll away from the frame member simultaneously with releasing the support film from the tape and winding up the support film on the wind-up roll.

6. The method for sticking a tape according to claim 3 or 4, which involves:
a fixing roll (32) for attaching and fixing the support film (10) to the frame member (18);
a sticking roll (34) for sticking the tape to the adherend; and
a clamping member (36) for clamping the support film across the width;
and comprises:
clamping the support film at longer edge portions thereof with the clamping member and arranging the tape such that the tape is included in the frame of the frame member;
causing the fixing roll to press the support film to fix the support film to the frame member;
causing the sticking roll to press the support film in the frame of the frame member to stick the tape to the adherend; and
releasing the support film from the tape by relatively moving the clamping member.

7. The method for sticking a tape (12) according to any one of claims 1 to 6, wherein the adherend is a semiconductor wafer and the tape is a protective tape.

8. An apparatus for sticking a tape (12) having a sticky surface to a surface of an adherend (14), **characterised by**:
a mounting table (16) on which the adherend is mounted;
a frame member (18) provided to include an adherend-mounting surface of the mounting table;
a fixing roll (22, 32) for attaching and fixing a long support film (10) to the frame member, the support film having a sticky and removable surface to which the tape is attached; and
a sticking roll (24, 34) for sticking the tape to the adherend;
the apparatus being constructed such that:
the support film is arranged above the frame member so that the tape is included in a frame of the frame member;
the fixing roll is caused to press the support film to fix the support film to the frame member;
the sticking roll is caused to press the support film in the frame of the frame member to stick the tape to the adherend; and
the support film is released from the tape.

9. The apparatus for sticking a tape (12) according to claim 8, which further comprises:
a wind-up roll (26) for the support film (10);
the apparatus being constructed such that:
the fixing roll (22) is moved toward the frame member while pressing the support film between the wind-up roll and a fixed end of the support film, thereby transferring the tape attached to the support film between the wind-up roll and the fixing roll in a direction opposite to the wind-up direction such that the tape is included in the frame of the frame member;
the fixing roll is caused to press the support film to fix the support film to the frame member (18);
the sticking roll is caused to press the support film in the frame of the frame member to stick the tape to the adherend; and
the fixing roll is moved away from the frame member and simultaneously the support film is released from the tape and is wound on the wind-up roll.

10. The apparatus for sticking a tape (12) according to claim 8, which further comprises a clamping member (36) for clamping the support film (10) across the width, the apparatus being constructed such that:
the support film is clamped at longer edge portions thereof with the clamping member and the tape is arranged such that the tape is included in the frame of the frame member;
the fixing roll (32) is caused to press the support film to fix the support film to the frame member;
the sticking roll (34) is caused to press the support film in the frame of the frame member to stick the tape to the adherend (14); and
the support film is released from the tape by relatively moving the clamping member.

11. The apparatus for sticking a tape (12) according to any one of claims 8 to 10, which further comprises aligning means capable of relatively moving the frame member (18) to which the support film (10) is attached and the mounting table (16) on which the adherend (14) is mounted to perform alignment of the tape in the frame of the frame member with the adherend.

12. An apparatus for sticking a tape (12) having a sticky surface to a surface of an adherend (14), **characterised by**:
a mounting table (16) on which the adherend is mounted;
a press roll (50) for pressing a long support film (10) having a sticky and removable surface to which the tape is attached, to stick the tape to the adherend; and
a clamping member (36) for clamping the support film across a width thereof;
the apparatus being constructed such that:
the support film is clamped at longer edge portions thereof with the clamping member and the clamping member is moved to cause the sticky surface of the tape on the support film to be opposed to a surface of the adherend mounted on the mounting table;
the press roll is caused to press the support film to stick the tape to the adherend; and
the support film is released from the tape by relatively moving the clamping member.

## Patentansprüche

1. Verfahren zum Kleben eines Bands (12) mit einer klebrigen Oberfläche auf eine Oberfläche eines Klebfügeteils (14), umfassend:
Vorbereiten des Bands zum Kleben auf das Klebfügeteil,
**gekennzeichnet durch**:
Aufbringen des Bands über eine nicht klebrige Oberfläche auf eine Trägerfolie (10) mit einer klebrigen und entfernbaren Oberfläche über die Oberfläche;
während die Trägerfolie Spannung ausgesetzt wird, Bewirken, dass die klebrige Oberfläche des Bands auf der Trägerfolie einer Oberfläche des Klebfügeteils, das an einem Montagetisch (16) angebracht ist, gegenüberliegt;
Kleben des Bands auf das Klebfügeteil **durch** Pressen der Trägerfolie; und
Ablösen der Trägerfolie von dem Band.

2. Verfahren zum Kleben eines Bands (12) nach Anspruch 1, das das Aufbringen mehrerer der Bänder auf die Trägerfolie (10) entlang einer längeren Richtung und das Überführen der Trägerfolie umfasst, wobei die Bänder auf jeweilige Klebfügeteile (14) durch Wiederholung der folgenden Vorgänge (i) bis (iv) geklebt werden:
(i) Bewirken, dass die klebrige Oberfläche des Bands auf der Trägerfolie einer Oberfläche des Klebfügeteils, das an dem Montagetisch angebracht ist, gegenüberliegt;
(ii) Kleben des Bands auf das Klebfügeteil durch Pressen der Trägerfolie;
(iii) Ablösen der Trägerfolie von dem Band; und
(iv) Anbringen eines neuen Klebfügeteils am Montagetisch.

3. Verfahren zum Kleben eines Bands (12) nach einem der Ansprüche 1 oder 2, das ein Rahmenglied (18) zum Fixieren der Trägerfolie (10) beinhaltet und Folgendes umfasst:
derartiges Anbringen und Fixieren der Trägerfolie am Rahmenglied, dass das Band in einem Rahmen des Rahmenglieds enthalten ist;
Bewirken, dass die klebrige Oberfläche des Bands im Rahmen des Rahmenglieds einer Oberfläche des Klebfügeteils, das an dem Montagetisch (16) angebracht ist, gegenüberliegt; und
Kleben des Bands auf das Klebfügeteil durch Pressen der Trägerfolie im Rahmen des Rahmenglieds.

4. Verfahren zum Kleben eines Bands (12) nach Anspruch 3, das relatives Bewegen des Rahmenglieds (18), an dem die Trägerfolie (10) angebracht ist, und des Montagetischs (16), an dem das Klebfügeteil angebracht ist, zum Ausführen einer Ausrichtung des Bands im Rahmen des Rahmenglieds am Klebfügeteil umfasst.

5. Verfahren zum Kleben eines Bands nach einem der Ansprüche 3 oder 4, das Folgendes beinhaltet:
eine Fixierwalze (22) zum Anbringen und Fixieren der Trägerfolie (10) am Rahmenglied (18);
eine Klebewalze (24) zum Kleben des Bands auf das Klebfügeteil;
eine Aufwickelrolle (26) für die Trägerfolie; und
ein festes Ende der Trägerfolie;
und Folgendes umfasst:
Bewegen der Fixierwalze zum Rahmenglied hin, während bewirkt wird, dass die Fixierwalze die Trägerfolie zwischen der Aufwickelrolle und dem festen Ende presst, wodurch das Band, das auf der Trägerfolie aufgebracht ist, zwischen der Aufwickelrolle und der Fixierwalze in einer Gegenrichtung zur Aufwickelrichtung überführt wird, sodass das Band im Rahmen des Rahmenglieds enthalten ist;
Bewirken, dass die Fixierwalze die Trägerfolie zum Fixieren der Trägerfolie am Rahmenglied presst;
Bewirken, dass die Klebewalze (24) die Trägerfolie im Rahmen des Rahmenglieds zum Kleben des Bands auf das Klebfügeteil presst; und
Wegbewegen der Fixierwalze vom Rahmenglied gleichzeitig mit dem Ablösen der Trägerfolie vom Band und Aufwickeln der Trägerfolie auf der Aufwickelrolle.

6. Verfahren zum Kleben eines Bands nach einem der Ansprüche 3 oder 4, das Folgendes enthält:
eine Fixierwalze (32) zum Anbringen und Fixieren der Trägerfolie (10) am Rahmenglied (18);
eine Klebewalze (34) zum Kleben des Bands auf das Klebfügeteil; und
ein Klemmglied (36) zum Einklemmen der Trägerfolie über die Breite hinweg;
und Folgendes umfasst:
Einklemmen der Trägerfolie an längeren Kantenabschnitten davon mit dem Klemmglied und derartiges Anordnen des Bands, dass das Band im Rahmen des Rahmenglieds enthalten ist;
Bewirken, dass die Fixierwalze die Trägerfolie zum Fixieren der Trägerfolie am Rahmenglied presst;
Bewirken, dass die Klebewalze die Trägerfolie im Rahmen des Rahmenglieds zum Kleben des Bands auf das Klebfügeteil presst; und
Ablösen der Trägerfolie vom Band durch relatives Bewegen des Klemmglieds.

7. Verfahren zum Kleben eines Bands (12) nach einem der Ansprüche 1 bis 6, wobei das Klebfügeteil ein Halbleiterwafer ist und das Band ein Schutzband ist.

8. Vorrichtung zum Kleben eines Bands (12) mit einer klebrigen Oberfläche auf eine Oberfläche eines Klebfügeteils (14), **gekennzeichnet durch**:
einen Montagetisch (16), an dem das Klebfügeteil angebracht ist;
ein Rahmenglied (18), das zum Enthalten einer Klebfügeteil-Anbringungsfläche des Montagetischs vorgesehen ist;
eine Fixierwalze (22, 32) zum Anbringen und Fixieren einer langen Trägerfolie (10) am Rahmenglied, wobei die Trägerfolie eine klebrige und entfernbare Oberfläche aufweist, auf die das Band aufgebracht ist; und
eine Klebewalze (24, 34) zum Kleben des Bands auf das Klebfügeteil;
wobei die Vorrichtung derart gebaut ist, dass:
die Trägerfolie derart über dem Rahmenglied angeordnet ist, dass das Band im Rahmen des Rahmenglieds enthalten ist;
bewirkt ist, dass die Fixierwalze die Trägerfolie zum Fixieren der Trägerfolie am Rahmenglied presst;
bewirkt ist, dass die Klebewalze die Trägerfolie im Rahmen des Rahmenglieds zum Kleben des Bands auf das Klebfügestück presst; und
die Trägerfolie vom Band abgelöst wird.

9. Vorrichtung zum Kleben eines Bands (12) nach Anspruch 8, die ferner Folgendes umfasst:
eine Aufwickelrolle (26) für die Trägerfolie (10);
wobei die Vorrichtung derart gebaut ist, dass:
die Fixierwalze (22) zum Rahmenglied hinbewegt wird, während sie die Trägerfolie zwischen der Aufwickelrolle und einem festen Ende der Trägerfolie presst, wodurch das Band, das auf der Trägerfolie aufgebracht ist, zwischen der Aufwickelrolle und der Fixierwalze in einer Gegenrichtung zur Aufwickelrichtung überführt wird, sodass das Band im Rahmen des Rahmenglieds enthalten ist;
bewirkt ist, dass die Fixierwalze die Trägerfolie zum Fixieren der Trägerfolie am Rahmenglied (18) presst;
bewirkt ist, dass die Klebewalze die Trägerfolie im Rahmen des Rahmenglieds zum Kleben des Bands auf das Klebfügeteil presst; und
die Fixierwalze vom Rahmenglied wegbewegt und gleichzeitig die Trägerfolie vom Band abgelöst und auf der Aufwickelrolle aufgewickelt wird.

10. Vorrichtung zum Kleben eines Bands (12) nach Anspruch 8, die ferner ein Klemmglied (36) zum Einklemmen der Trägerfolie (10) über die Breite hinweg umfasst, wobei die Vorrichtung derart gebaut ist, dass:
die Trägerfolie an längeren Kantenabschnitten davon mit dem Klemmglied eingeklemmt und das Band derart angeordnet wird, dass das Band im Rahmen des Rahmenglieds enthalten ist;
bewirkt ist, dass die Fixierwalze (32) die Trägerfolie zum Fixieren der Trägerfolie am Rahmenglied presst;
bewirkt ist, dass die Klebewalze (34) die Trägerfolie im Rahmen des Rahmenglieds zum Kleben des Bands auf das Klebfügeteil (14) presst; und
die Trägerfolie vom Band durch relatives Bewegen des Klemmglieds abgelöst wird.

11. Vorrichtung zum Kleben eines Bands (12) nach einem der Ansprüche 8 bis 10, die ferner Ausrichtungsmittel umfasst, welche imstande sind, das Rahmenglied (18), an dem die Trägerfolie (10) angebracht ist, und den Montagetisch (16), an dem das Klebfügeteil (14) angebracht ist, zum Ausführen einer Ausrichtung des Bands im Rahmen des Rahmenglieds am Klebfügeteil relativ zu bewegen.

12. Vorrichtung zum Kleben eines Bands (12) mit einer klebrigen Oberfläche auf eine Oberfläche eines Klebfügeteils (14), **gekennzeichnet durch**:
einen Montagetisch (16) an dem das Klebfügeteil angebracht ist;
eine Presswalze (50) zum Pressen einer langen Trägerfolie (10) mit einer klebrigen und entfernbaren Oberfläche, auf der ein Band aufgebracht ist, zum Kleben des Bands auf das Klebfügeteil, und
ein Klemmglied (36) zum Einklemmen der Trägerfolie über eine Breite davon hinweg;
wobei die Vorrichtung derart gebaut ist, dass:
die Trägerfolie an längeren Kantenabschnitten davon mit dem Klemmglied eingeklemmt und das Klemmglied bewegt wird, um zu bewirken, dass die klebrige Oberfläche des Bands auf der Trägerfolie einer Oberfläche des Klebfügeteils, das am Montagetisch angebracht ist, gegenüberliegt;
bewirkt ist, dass die Presswalze die Trägerfolie zum Kleben des Bands auf das Klebfügeteil presst; und
die Trägerfolie **durch** relatives Bewegen des Klemmglieds vom Band abgelöst wird.

## Revendications

1. Procédé de collage d'un ruban (12) ayant une surface collante sur une surface d'un substrat (14), comprenant :
la préparation du ruban pour le coller sur le substrat,
**caractérisé par** :
la pose du ruban par l'intermédiaire d'une surface non collante sur un film support (10) ayant une surface collante et détachable par l'intermédiaire de la surface ;
tout en soumettant le film support à une tension, l'incitation de la surface collante du ruban sur le film support à s'opposer à une surface du substrat monté sur une table de montage (16) ;
le collage du ruban sur le substrat en pressant sur le film support ; et
le détachement du film support d'avec le ruban.

2. Procédé de collage d'un ruban (12) selon la revendication 1, lequel comprend la fixation d'une pluralité des rubans sur le film support (10) dans un sens plus long, et le transfert du film support de telle sorte que les rubans soient collés sur des substrats respectifs (14) par répétition des opérations (i) à (iv) ;
(i) l'incitation de la surface collante du ruban sur le film support à s'opposer à une surface du substrat monté sur la table de montage ;
(ii) le collage du ruban sur le substrat en pressant sur le film support ;
(iii) le détachement du film support d'avec le ruban ; et
(iv) le montage d'un nouvel substrat sur la table de montage.

3. Procédé de collage d'un ruban (12) selon la revendication 1 ou 2, lequel implique un élément d'armature (18) pour fixer le film support (10) et comprend :
la pose et la fixation du film support sur l'élément d'armature de telle sorte que le ruban soit inclus dans un cadre de l'élément d'armature ;
l'incitation de la surface collante du ruban dans le cadre de l'élément d'armature à s'opposer à une surface du substrat monté sur la table de montage (16) ; et
le collage du ruban sur le substrat en pressant le film support dans le cadre de l'élément d'armature.

4. Procédé de collage d'un ruban (12) selon la revendication 3, lequel comprend le déplacement relatif de l'élément d'armature (18) sur lequel le film support (10) est posé et de la table de montage (16) sur laquelle le substrat est monté pour aligner le ruban dans le cadre de l'élément d'armature avec le substrat.

5. Procédé de collage d'un ruban selon la revendication 3 ou 4, lequel implique :
un rouleau de fixation (22) pour poser et fixer le film support (10) sur l'élément d'armature (18) ;
un rouleau de collage (24) pour coller le ruban sur le substrat ;
un rouleau d'enroulement (26) du film support ; et
une extrémité fixe du film support ;
et comprend :
le déplacement du rouleau de fixation vers l'élément d'armature tout en incitant le rouleau de fixation à presser le film support entre le rouleau d'enroulement et l'extrémité fixe, transférant ainsi le ruban posé sur le film support entre le rouleau d'enroulement et le rouleau de fixation dans un sens opposé au sens d'enroulement de telle sorte que le ruban soit inclus dans le cadre de l'élément d'armature ;
l'incitation du rouleau de fixation à presser le film support pour fixer le film support contre l'élément d'armature ;
l'incitation du rouleau de collage (24) à presser le film support dans le cadre de l'élément d'armature pour coller le ruban sur le substrat ; et
le déplacement du rouleau de fixation pour l'écarter de l'élément d'armature tout en détachant le film support du ruban et enroulant le film support sur le rouleau d'enroulement.

6. Procédé de collage d'un ruban selon la revendication 3 ou 4, lequel implique :
un rouleau de fixation (32) pour poser et fixer le film support (10) sur l'élément d'armature (18) ;
un rouleau de collage (34) pour coller le ruban sur le substrat ; et
un élément de serrage (36) pour serrer le film support en travers de la largeur ;
et comprend :
le serrage du film support au niveau de ses parties de bords plus longues avec l'élément de serrage et la disposition du ruban de telle sorte que le ruban soit inclus dans le cadre de l'élément d'armature ;
l'incitation du rouleau de fixation à presser le film support pour fixer le film support sur l'élément d'armature ;
l'incitation du rouleau de collage à presser le film support dans le cadre de l'élément d'armature pour coller le ruban sur le substrat ; et
le détachement du film support d'avec le ruban en déplaçant relativement l'élément de serrage.

7. Procédé de collage d'un ruban (12) selon l'une quelconque des revendications 1 à 6, dans lequel le substrat est une tranche semi-conductrice et le ruban est un ruban de protection.

8. Appareil de collage d'un ruban (12) ayant une surface collante sur une surface d'un substrat (14), **caractérisé par** :
une table de montage (16) sur laquelle est monté le substrat ;
un élément d'armature (18) fourni pour inclure une surface de montage de substrat de la table de montage ;
un rouleau de fixation (22, 32) pour poser et fixer un long film support (10) sur l'élément d'armature, le film support ayant une surface collante et détachable sur laquelle le ruban est posé ; et
un rouleau de collage (24, 34) pour coller le ruban sur le substrat ;
l'appareil étant construit de telle sorte que :
le film support soit agencé au-dessus de l'élément d'armature de manière à ce que le ruban soit inclus dans un cadre de l'élément d'armature ;
le rouleau de fixation soit incité à presser le film support pour fixer le film support sur l'élément d'armature ;
le rouleau de collage soit amené à presser le film support dans le cadre de l'élément d'armature pour coller le ruban sur le substrat ; et
le film support soit détaché du ruban.

9. Appareil de collage d'un ruban (12) selon la revendication 8, lequel comprend en outre :
un rouleau d'enroulement (26) du film support (10) ; et
l'appareil étant construit de telle sorte que :
le rouleau de fixation (22) soit déplacé vers l'élément d'armature tout en pressant le film support entre le rouleau d'enroulement et une extrémité fixe du film support, transférant ainsi le ruban posé sur le film support entre le rouleau d'enroulement et le rouleau de fixation dans un sens opposé au sens d'enroulement de telle sorte que le ruban soit inclus dans le cadre de l'élément d'armature ;
le rouleau de fixation est incité à presser le film support pour fixer le film support sur l'élément d'armature (18) ;
le rouleau de collage soit amené à presser le film support dans le cadre de l'élément d'armature pour coller le ruban sur le substrat ; et
le rouleau de fixation est écarté de l'élément d'armature et simultanément le film support est détaché du ruban et est enroulé sur le rouleau d'enroulement.

10. Appareil de collage d'un ruban (12) selon la revendication 8, lequel comprend en outre un élément de serrage (36) pour serrer le film support (10) en travers de la largeur, l'appareil étant construit de telle sorte que :
le film support soit serré au niveau de ses parties de bords plus longues avec l'élément de serrage et le ruban soit disposé de telle sorte que le ruban soit inclus dans le cadre de l'élément d'armature ;
le rouleau de fixation (32) soit incité à presser le film support afin de fixer le film support sur l'élément d'armature ;
le rouleau de collage (34) soit incité à presser le film support dans le cadre de l'élément d'armature pour coller le ruban sur le substrat (14) ; et
le film support soit détaché du ruban en déplaçant relativement l'élément de serrage.

11. Appareil de collage d'un ruban (12) selon l'une quelconque des revendications 8 à 10, lequel comprend en outre un moyen d'alignement capable de déplacer relativement l'élément d'armature (18) sur lequel le film support (10) est posé et la table de montage (16) sur laquelle le substrat (14) est monté pour aligner le ruban dans le cadre de l'élément d'armature avec le substrat.

12. Appareil de collage d'un ruban (12) ayant une surface collante sur une surface d'un substrat (14), **caractérisé par** :
une table de montage (16) sur laquelle est monté le substrat ;
un rouleau presseur (50) pour presser un long film support (10) ayant une surface collante et détachable sur laquelle est posée le ruban, pour coller le ruban sur le substrat ; et
un élément de serrage (36) pour serrer le film support en travers d'une largeur de celui-ci ;
l'appareil étant construit de telle sorte que :
le film support soit serré au niveau de ses parties de bords plus longues avec l'élément de serrage et l'élément de serrage soit déplacé pour inciter la surface collante du ruban sur le film support à s'opposer à une surface du substrat monté sur la table de montage ;
le rouleau presseur soit incité à presser le film support pour coller le ruban sur le substrat ; et
le film support soit détaché du ruban en déplaçant relativement l'élément de serrage.
